# DEMANDE DE BREVET EUROPEEN

(11) **EP 4 791 129 A1**
(43) Date de publication de la demande: **12.08.2026**
(21) Numéro de dépôt: 26157670.6
(22) Date de dépôt: 10.02.2026
(51) Int. Cl.: H05K 7/14, H05K 3/32, H05K 1/14, H05K 3/3447, H05K 3/36

(54) **ENSEMBLE ÉLECTRONIQUE COMPORTANT UNE FOURCHE DE CONNEXION**

(30) Priorité: 11.02.2025 FR 2501427
(71) Demandeur: Valeo Electrification, 95892 Cergy Pontoise (FR)
(72) Inventeur: HENNEGUET, Romain, 62630 Etaples-sur-Mer (FR); THANGARAJAN, Vivek, 600130 Chennai, Tamil Nadu (IN); MARSHAL, Belber, 600130 Chennai, Tamil Nadu (IN)
(74) Mandataire: Valeo Powertrain Systems

(57) **Abrégé**

Ensemble électronique (1) comportant :
- au moins un module électronique (2) de puissance comportant au moins une broche de connexion (3) notamment coudée,
- une carte de circuit imprimé (4) comportant des pistes de connexion électrique, et au moins un orifice de connexion électrique (5),
- un connecteur électrique intermédiaire (7) placé entre le module électronique (2) de puissance et la carte de circuit imprimé (4), comportant :
• au moins une fourche de connexion (8) arrangée pour être sertie à chaud sur la broche de connexion (3) du module électronique (2) de puissance,
• au moins une broche intermédiaire, connectée électriquement à la fourche de connexion (8), et configurée pour être insérée dans l'au moins un orifice de connexion électrique (5) de la carte de circuit imprimé (4).

## Description

### Domaine de l'invention

La présente invention concerne un ensemble électronique comportant des composants électroniques de puissance, notamment configuré pour être intégré dans un onduleur.

### État de la technique

On connaît par la demande de brevet EP4362083A1 un ensemble électronique comportant des modules électroniques de puissance intercalés entre deux dispositifs de refroidissements arrangés pour refroidir les modules électroniques de puissance.

Les modules électroniques de puissance comportent des broches de connexion arrangées pour transmettre des signaux aux modules de puissance. Ces broches de connexion sont donc connectées électriquement à un connecteur intermédiaire monté en force sur une carte électronique.

Cette méthode de connexion nécessite le soudage des broches de connexion des modules électroniques de puissance sur le connecteur intermédiaire. Cette méthode représente une étape d'assemblage coûteuse, et nécessite un positionnement relatif précis des modules électroniques de puissance et du connecteur intermédiaire.

L'invention vise notamment à répondre à ces inconvénients.

### Exposé de l'invention

L'invention concerne un ensemble électronique comportant :
- au moins un module électronique de puissance comportant au moins une broche de connexion notamment coudée,
- une carte de circuit imprimé comportant des pistes de connexion électrique, et au moins un orifice de connexion électrique,
- un connecteur électrique intermédiaire placé entre le module électronique de puissance et la carte de circuit imprimé, comportant :
   - au moins une fourche de connexion arrangée pour être sertie à chaud sur la broche de connexion du module électronique de puissance,
   - au moins une broche intermédiaire, connectée électriquement à la fourche de connexion, et configurée pour être insérée dans l'au moins un orifice de connexion électrique de la carte de circuit imprimé.

Selon un aspect de l'invention, la fourche de connexion a une forme en U, et comporte deux branches de longueur L espacée d'un écartement E.

Selon un aspect de l'invention, l'écartement E de la fourche de connexion permet le sertissage à chaud de la fourche sur la broche de connexion coudée avec une tolérance sur le placement relatif de la fourche et de la broche de connexion supérieur ou égal à 1mm.

Alternativement, la fourche de connexion peut avoir toute autre forme, par exemple une forme circulaire, ou rectangulaire.

Selon un aspect de l'invention, la fourche de connexion peut déterminer un contour ouvert ou fermé.

Selon un aspect de l'invention, la fourche de connexion, la broche de connexion et la broche intermédiaire sont réalisés en matériaux électriquement conducteur, notamment en métal ou alliage métallique, éventuellement revêtu, notamment en cuivre ou en alliage de cuivre.

Selon un aspect de l'invention, la fourche de connexion, la broche intermédiaire et la broche de connexion sont réalisés dans des alliages de cuivres différents.

Selon un aspect de l'invention, le connecteur électrique intermédiaire comporte un cadre.

Selon un aspect de l'invention, le cadre comporte une pluralité d'ouvertures de positionnement, notamment autant d'ouvertures de positionnement que de modules électronique de puissance, chaque ouverture de positionnement étant arrangée pour accueillir un module électronique de puissance.

Selon un aspect de l'invention, l'ensemble électronique comporte une pluralité de modules électroniques de puissance, par exemple trois modules électroniques de puissance, et le connecteur électrique intermédiaire comporte trois ouvertures de positionnement.

Selon un aspect de l'invention, le cadre est réalisé en matériau isolant, notamment en plastique.

Selon un aspect de l'invention, la fourche de connexion et la broche intermédiaire sont intégrées de manière permanente dans le cadre.

Selon un aspect de l'invention, le cadre est surmoulé sur la broche intermédiaire et la fourche de connexion et les intègre de manière inextricable.

Selon un aspect de l'invention, la broche intermédiaire a une géométrie d'ajustement par pression.

Selon un aspect de l'invention, la broche intermédiaire est connectée électriquement à une piste électrique de la carte de circuit via un orifice de connexion de la carte de circuit imprimé par ajustement de forme et/ou verrouillage par friction et/ou verrouillage du matériau.

Notamment, la broche intermédiaire est connectée électriquement à une piste électrique de la carte de circuit imprimé par ajustement serré, l'insertion de la broche intermédiaire dans l'orifice de connexion de la carte de circuit imprimé.

Selon un aspect de l'invention, le module électronique de puissance est sensiblement plat, et comporte une face supérieure, une face inférieure et des surfaces latérales.

Selon un aspect de l'invention, l'ensemble électronique comporte au moins un dispositif de refroidissement, placé en contact thermique avec au moins un module électronique de puissance.

Notamment, l'ensemble électronique comporte deux dispositif de refroidissement :
- un premier dispositif de refroidissement placé en contact thermique avec la face supérieure du module électronique de puissance,
- un deuxième dispositif de refroidissement placé en contact thermique avec la deuxième phase du module électronique de puissance.

Selon un aspect de l'invention, le connecteur électrique intermédiaire est intercalé entre le premier dispositif de refroidissement et le deuxième dispositif de refroidissement, et forme un empilement avec le premier dispositif de refroidissement et le deuxième dispositif de refroidissement.

Selon un aspect de l'invention, les broche de connexion des modules électroniques de puissance sont placées sur des faces latérales des modules électroniques de puissance.

Selon un aspect de l'invention, chaque broche de connexion comporte :
- une portion horizontale, sensiblement parallèle à la face supérieure du module électronique de puissance,
- une portion verticale, dans une direction sensiblement normale à la face supérieure du module électronique de puissance,
- un coude reliant la portion horizontale et la portion verticale de la broche de connexion.

Avantageusement, l'utilisation de broches de connexion coudées placées sur une face latérale d'un module électronique de puissance permet de réaliser la connexion électrique de la carte électronique au module électronique de puissance lorsque les faces supérieures et inférieures du module électronique de puissance sont placées au contact de dispositifs de refroidissement.

Selon un aspect de l'invention, l'utilisation de broche de connexion coudées permet d'insérer les broche de connexion dans les fourches de connexion et de réaliser une connexion électrique sans soudage.

Avantageusement, l'utilisation de fourche de connexion permet d'augmenter les tolérances pour la connexion du connecteur électrique intermédiaire aux broche de connexion coudées des module électronique de puissance.

Selon un aspect de l'invention, l'utilisation de tolérances plus grandes permet un assemblage plus fiable de l'ensemble électronique pour la production en série.

Avantageusement, l'utilisation de sertissage à chaud pour la connexion électrique permet de diminuer les coûts et d'augmenter la fiabilité de ces connexions comparée à une connexion par un procédé de soudage.

L'invention concerne également un procédé pour interconnecter électriquement un module électronique de puissance d'un ensemble électronique avec une carte de circuit imprimé de cet ensemble électronique, comprenant les étapes suivantes :
- une étape de placement d'au moins une broche de connexion du module électronique de puissance en regard d'au moins une fourche de connexion d'un connecteur électrique intermédiaire,
- une étape de sertissage à chaud de l'au moins une fourche de connexion sur l'au moins une broche de connexion,
- une étape de placement de la carte de circuit imprimé en regard du connecteur électrique intermédiaire, de sorte que les orifices de connexion électrique de la carte de circuit imprimé soient placés en regard des broche intermédiaire du carte de circuit imprimé,
- une étape d'insertion en force les broche intermédiaire du connecteur électrique intermédiaire dans les orifices de connexion de la carte de circuit imprimé.

Selon un aspect de l'invention, l'étape de sertissage à chaud comporte une étape de chauffage de la fourche de connexion, et une étape de déformation de la fourche de connexion, notamment de déformation des branches de la fourche de connexion, de manière à placer la fourche de connexion au contact de la broche de connexion et à solidariser ensemble la fourche de connexion et la broche de connexion.

### Liste des figures

D'autres caractéristiques, détails et avantages de l'invention ressortiront plus clairement à la lecture de la description qui suit d'une part, et de plusieurs exemples de réalisation donnés à titre indicatif et non limitatif en référence aux dessins schématiques annexés d'autre part, sur lesquels :
[Fig 1] La figure 1 est une représentation schématique d'un ensemble électronique selon l'invention.
[Fig. 2] La figure 2 est une vue rapprochée en coupe d'un ensemble électronique selon l'invention.

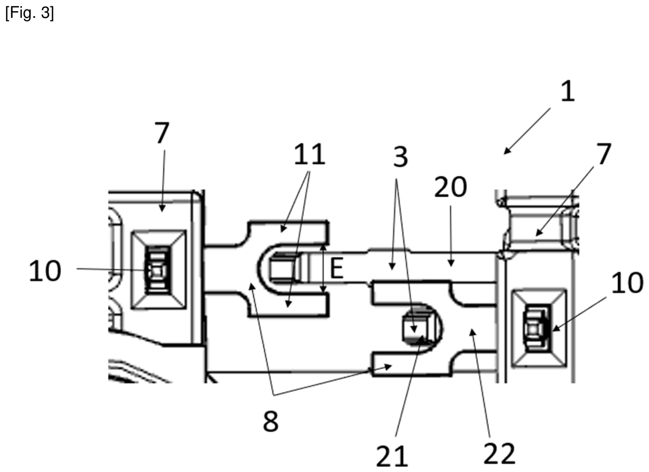

[Fig. 3] La figure 3 est une vue rapprochée de dessus d'un ensemble électronique selon l'invention.

Les caractéristiques, variantes et les différentes formes de réalisation de l'invention peuvent être associées les unes avec les autres, selon diverses combinaisons, dans la mesure où elles ne sont pas incompatibles ou exclusives les unes par rapport aux autres. On pourra notamment imaginer des variantes de l'invention ne comprenant qu'une sélection de caractéristiques décrites par la suite de manière isolée des autres caractéristiques décrites, si cette sélection de caractéristiques est suffisante pour conférer un avantage technique et/ou pour différencier l'invention par rapport à l'état de la technique antérieur.

### Description détaillée

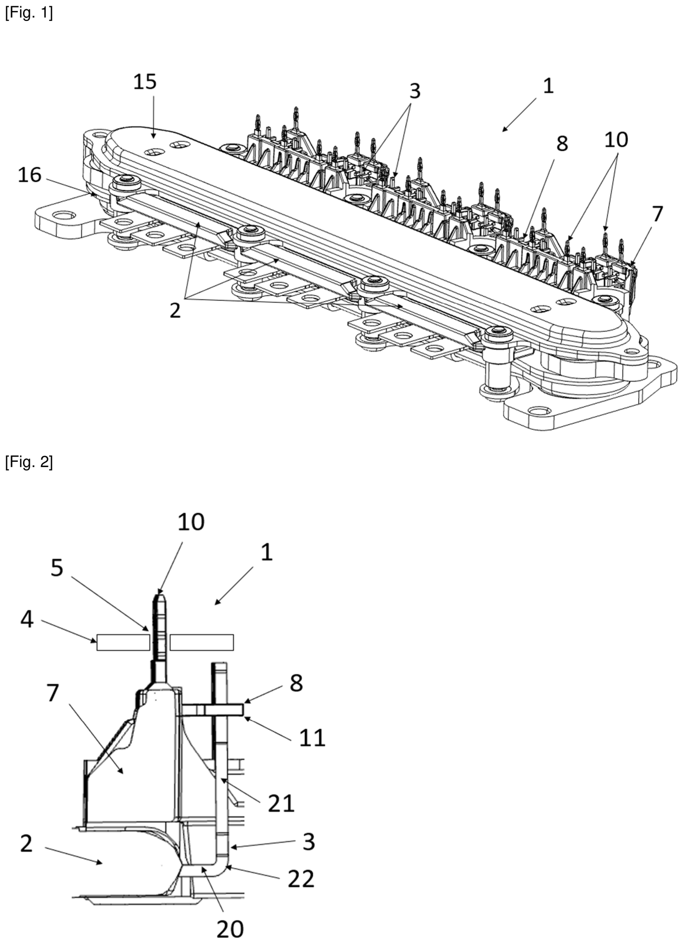

On a représenté sur les figures 1 et 2, un ensemble électronique 1 selon l'invention.

L'ensemble électronique 1 comporte
- trois modules électroniques 2 de puissance comportant chacun au moins une broche de connexion 3 notamment coudée,
- une carte de circuit imprimé 4, uniquement représentée sur la figure 2, comportant des pistes de connexion électrique, et au moins un orifice de connexion électrique 5,
- un connecteur électrique intermédiaire 7 placé entre le module électronique 2 de puissance et la carte de circuit imprimé 4, comportant :
   - au moins une fourche de connexion 8 arrangée pour être sertie à chaud sur la broche de connexion 3 du module électronique 2 de puissance,
   - au moins une broches intermédiaires 10, connectée électriquement à la fourche de connexion 8, et configurée pour être insérée dans l'au moins un orifice de connexion électrique 5 de la carte de circuit imprimé 4,

Ici, chaque module électronique 2 de puissance comporte sept broches de connexions 3 coudées, et le connecteur électrique intermédiaire 7 comporte sept fourches de connexion 8 8 et sept broches intermédiaires 10.

Les fourches de connexion 8 8 ont une forme en U, et comportent deux branches 11 de longueur L espacée d'un écartement E.

L'écartement E des fourches de connexion 8 8 permet le sertissage à chaud des fourches de connexion 8 sur les broches de connexion 3 coudées avec une tolérance sur le placement relatif de la fourche et de la broche de connexion 3 supérieur ou égal à 1mm.

Selon un mode de réalisation de l'invention non représenté, au moins une fourche de connexion 8 peut avoir toute autre forme, par exemple une forme circulaire, ou rectangulaire, et peuvent déterminer un contour ouvert ou fermé.

Les fourches de connexion 8, les broches de connexion 3 et les broches intermédiaires 10 sont réalisées en matériaux électriquement conducteur, notamment en métal ou alliage métallique, éventuellement revêtu, notamment en cuivre ou en alliage de cuivre.

Les fourches de connexion 8, les broches intermédiaires 10 et les broches de connexion 3 sont réalisés respectivement dans des alliages de cuivres différents.

Le connecteur électrique intermédiaire 7 comporte un cadre 30 comportant une pluralité d'ouvertures de positionnement, notamment autant d'ouvertures de positionnement que de modules électroniques 2 de puissance, chaque ouverture de positionnement étant arrangée pour accueillir un module électronique 2 de puissance.

L'ensemble électronique 1 comporte une pluralité de modules électroniques 2 de puissance, par exemple trois modules électroniques 2 de puissance, et le connecteur électrique intermédiaire 7 comporte trois ouvertures de positionnement.

La fourches de connexion 8 et les broches intermédiaires 10 sont intégrées de manière permanente dans le cadre 30.

Le cadre 30 est réalisé en matériau isolant, notamment en plastique, et est surmoulé sur les broches intermédiaires 10 et les fourches de connexion 8 et les intègre de manière inextricable.

Les broches intermédiaires 10 ont une géométrie d'ajustement par pression.

Les broches intermédiaires 10 sont connectées électriquement à une piste électrique de la carte de circuit via un orifice de connexion de la carte de circuit imprimé 4 par ajustement de forme et/ou verrouillage par friction et/ou verrouillage du matériau.

Notamment, les broches intermédiaires 10 sont connectées électriquement à une piste électrique de la carte de circuit imprimé 4 par ajustement serré, l'insertion de la broches intermédiaires 10 dans l'orifice de connexion électrique 5 de la carte de circuit imprimé 4.

Le module électronique 2 de puissance est sensiblement plat, et comporte une face supérieure, une face inférieure et des surfaces latérales.

L'ensemble électronique 1 comporte au moins un dispositif de refroidissement, placé en contact thermique avec au moins un module électronique 2 de puissance.

Ici, l'ensemble électronique 1 comporte deux dispositif de refroidissement :
- un premier dispositif de refroidissement 15 placé en contact thermique avec la face supérieure du module électronique 2 de puissance,
- un deuxième dispositif de refroidissement 16 placé en contact thermique avec la deuxième phase du module électronique 2 de puissance.

Le connecteur électrique intermédiaire 7 est intercalé entre le premier dispositif de refroidissement 15 et le deuxième dispositif de refroidissement 16, et forme un empilement avec le premier dispositif de refroidissement 15 et le deuxième dispositif de refroidissement 16.

Les broche de connexion 3 des modules électroniques 2 de puissance sont placées sur des faces latérales des modules électroniques 2 de puissance.

Chaque broche de connexion 3 comporte :
- une portion horizontale 20, sensiblement parallèle à la face supérieure du module électronique 2 de puissance,
- une portion verticale 21, dans une direction sensiblement normale à la face supérieure du module électronique 2 de puissance,
- un coude 22 reliant la portion horizontale et la portion verticale de la broche de connexion 3.

L'utilisation de broches de connexion 3 coudées permet d'insérer les broches de connexion 3 dans les fourches de connexion 8 et de réaliser une connexion électrique sans soudage.

Avantageusement, l'utilisation de fourches de connexion 8 permet d'augmenter les tolérances pour la connexion du connecteur électrique intermédiaire 7 aux broche de connexion 3 coudées des module électronique 2 de puissance.

L'utilisation de tolérances plus grandes permet un assemblage plus fiable de l'ensemble électronique 1 pour la production en série.

Avantageusement, l'utilisation de sertissage à chaud pour la connexion électrique permet de diminuer les coûts et d'augmenter la fiabilité de ces connexions comparée à une connexion par un procédé de soudage.

## Revendications

1. Ensemble électronique (1) comportant :
- au moins un module électronique (2) de puissance comportant au moins une broche de connexion (3) notamment coudée,
- une carte de circuit imprimé (4) comportant des pistes de connexion électrique, et au moins un orifice de connexion électrique (5),
- un connecteur électrique intermédiaire (7) placé entre le module électronique (2) de puissance et la carte de circuit imprimé (4), comportant :
• au moins une fourche de connexion (8) arrangée pour être sertie à chaud sur la broche de connexion (3) du module électronique (2) de puissance,
• au moins une broche intermédiaire, connectée électriquement à la fourche de connexion (8), et configurée pour être insérée dans l'au moins un orifice de connexion électrique (5) de la carte de circuit imprimé (4).

2. Ensemble électronique (1) selon la revendication 1, dans lequel la fourche de connexion (8) a une forme en U, et comporte deux branches (11) de longueur L espacée d'un écartement E, cet écartement E de la fourche de connexion (8) permettant le sertissage à chaud de la fourche sur la broche de connexion (3) coudée avec une tolérance sur le placement relatif de la fourche et de la broche de connexion (3) supérieur ou égal à 1mm.

3. Ensemble électronique (1) selon l'une des revendications précédentes, dans lequel la fourche de connexion (8), la broche intermédiaire et la broche de connexion (3) sont réalisés dans des alliages de cuivres différents.

4. Ensemble électronique (1) selon l'une des revendications précédentes, dans lequel le connecteur électrique intermédiaire (7) comporte un cadre (30) réalisé en matériau isolant, notamment en plastique, et la fourche de connexion (8) et la broche intermédiaire sont intégrées de manière permanente dans le cadre (30).

5. Ensemble électronique (1) selon l'une des revendications précédentes, dans lequel la broche intermédiaire a une géométrie d'ajustement par pression.

6. Ensemble électronique (1) selon l'une des revendications précédentes, dans lequel la broche intermédiaire est connectée électriquement à une piste électrique de la carte de circuit via un orifice de connexion de la carte de circuit imprimé (4) par ajustement de forme et/ou verrouillage par friction et/ou verrouillage du matériau.

7. Ensemble électronique (1) selon l'une des revendications précédentes, comportant au moins un dispositif de refroidissement, placé en contact thermique avec au moins un module électronique (2) de puissance.

8. Ensemble électronique (1) selon l'une des revendications précédentes, dans lequel les broche de connexion (3) des modules électroniques (2) de puissance sont placées sur des faces latérales des modules électroniques (2) de puissance.

9. Ensemble électronique (1) selon l'une des revendications précédentes, dans lequel chaque broche de connexion (3) comporte :
- une portion horizontale (20), sensiblement parallèle à la face supérieure du module électronique (2) de puissance,
- une portion verticale (21), dans une direction sensiblement normale à la face supérieure du module électronique (2) de puissance,
- un coude (22) reliant la portion horizontale (20) et la portion verticale (21) de la broche de connexion (3).

10. Procédé pour interconnecter électriquement un module électronique (2) de puissance d'un ensemble électronique (1) selon l'une des revendications précédentes avec une carte de circuit imprimé (4) de cet ensemble électronique (1), comprenant les étapes suivantes :
- une étape de placement d'au moins une broche de connexion (3) du module électronique (2) de puissance en regard d'au moins une fourche de connexion (8) d'un connecteur électrique intermédiaire (7),
- une étape de sertissage à chaud de l'au moins une fourche de connexion (8) sur l'au moins une broche de connexion (3),
- une étape de placement de la carte de circuit imprimé (4) en regard du connecteur électrique intermédiaire (7), de sorte que les orifices de connexion électrique de la carte de circuit imprimé (4) soient placés en regard des broche intermédiaire du carte de circuit imprimé (4),
- une étape d'insertion en force les broche intermédiaire du connecteur électrique intermédiaire (7) dans les orifices de connexion de la carte de circuit imprimé (4).

11. Procédé selon la revendication 10, dans lequel l'étape de sertissage à chaud comporte une étape de chauffage de la fourche de connexion (8), et une étape de déformation de la fourche de connexion (8), notamment de déformation des branches (11) de la fourche de connexion (8), de manière à placer la fourche de connexion (8) au contact de la broche de connexion (3) et à solidariser ensemble la fourche de connexion (8) et la broche de connexion (3).
